# EUROPEAN PATENT APPLICATION

(11) **EP 1 795 550 A1**
(43) Date of publication of application: **13.06.2007**
(21) Application number: 05788192.2
(22) Date of filing: 29.09.2005
(51) Int. Cl.: C08G 59/68, H01L 23/29, H01L 23/31

(54) **EPOXY RESIN COMPOSITION FOR OPTICAL SEMICONDUCTOR ENCAPSULATION**

(30) Priority: 01.10.2004 JP 2004289847; 01.10.2004 JP 2004289850
(71) Applicant: NIPPON KAYAKU KABUSHIKI KAISHA, Tokyo 102-8172 (JP)
(72) Inventor: OSHIMI, Katsuhiko, Nippon Kayuku Kabushiki Kaisha, Tokyo 115-0042 (JP); NAKAYAMA, Koji, Nippon Kayuku Kabushiki Kaisha, Tokyo 102-8172 (JP); UMEYAMA, Chie, Nippon Kayuku Kabushiki Kaisha, Tokyo 115-0042 (JP); KAWADA, Yoshihiro, Nippon Kayuku Kabushiki Kaisha, Tokyo 115-0042 (JP); MIYAGAWA, Naofusa, Nippon Kayaku Kabushiki Kaisha, Tokyo 115-0042 (JP)
(74) Representative: Gille Hrabal Struck Neidlein Prop Roos
(86) International application number: PCT/JP2005/018010
(87) International publication number: WO 2006/038530

(57) **Abstract**

Disclosed is an epoxy resin composition for optical semiconductor encapsulation which contains an epoxy resin obtained by co-hydrolysis/condensation of alkoxy silicon compounds expressed as XSi(R₁)ₙ(OR₂)₃₋ₙ (wherein X represents an organic group having an epoxy group; R₁ represents a substituted or unsubstituted alkyl group having 1-10 carbon atoms, a substituted or unsubstituted aryl group or a substituted or unsubstituted alkenyl group having 2-5 carbon atoms; R₂ represents an alkyl group having 1-4 carbon atoms; n represents an integer of 0-2; and when more than one R₁ are included, they may be the same as or different from each other) or co-hydrolysis/condensation of such an alkoxy silicon compound and another specific alkoxy silicon compound.

## Description

### Technical Field

The present invention relates to an epoxy resin composition for sealing an optical semiconductor excellent in transparency and an optical semiconductor device sealed by a cured product thereof.

### Background Art

Conventionally, as sealing materials for optical semiconductor elements such as LEDs, CCDs and photocouplers, epoxy resin sealing materials have been widely used because they are preferable in terms of the balance between the properties and economical efficiency. In particular, as conventional sealing materials for optical semiconductors, aromatic epoxy resins, typically bisphenol A types, are generally used. Recently, in the field of LED technologies, LEDs emitting ultraviolet light (ultraviolet LEDs) have been developed for successful production of white LEDs. The above-described aromatic epoxy resins, however, have a problem that they are deteriorated by ultraviolet light at about 400 nm.

To solve the problem caused by short wavelength light as described above, a method using an aromatic ring-hydrogenated product of an aromatic epoxy resin as an epoxy resin has been proposed (JP-A-2003-82062), but it cannot be said that this technique is satisfactory. Further, a condensation product of an alkoxy-silicon compound having an epoxy group has been proposed (JP-A-6-298940), but their uses as sealing materials for optical semiconductors are not described.

The present invention is aimed at providing an epoxy resin composition for sealing an optical semiconductor with little degradation by ultraviolet light.

### Desclosure of Invention

The present inventors have conducted intensive studies to solve the above-described problem and as a result, have accomplished the present invention. Accordingly, the present invention is as follows.
(1) An epoxy resin composition for sealing an optical semiconductor, comprising
   (A) an epoxy resin obtained by hydrolysis/condensation of an alkoxy-silicon compound(s) represented by the formula (1) by itself or different alkoxy-silicon compounds represented by the formula (1) and the formula (2), respectively:

      XSi(R₁)ₙ(OR₂)₃₋ₙ (1)

      (wherein X is an organic group having an epoxy group, R₁ is a substituted or unsubstituted alkyl group having 1 to 10 carbon atoms, a substituted or unsubstituted aryl group or a substituted or unsubstituted alkenyl group having 2 to 5 carbon atoms, R₂ is an alkyl group having 1 to 4 carbon atoms, n is an integer of 0 to 2, provided that a plurality of R₁'s exist, the plurality of R₁'s each may be the same or different),

      Xₖ(R₃)ₘSi(OR₄)₄₋₍ₖ₊ₘ₎ (2)

      (wherein X is an organic group having an epoxy group, R₃ is a substituted or unsubstituted alkyl group having 1 to 10 carbon atoms, a substituted or unsubstitu-ted aryl group or a substituted or unsubstituted unsaturated aliphatic residue, k and m are each independently an integer of 0 to 3 and k+m is 0 to 3, and when a plurality of R₃'s exist, the plurality of R₃'s each may be the same or different, and R₄ is an alkyl group having 1 to 4 carbon atoms); and
   (B) (i) a cationic polymerization initiator or (ii) a curing agent and a curing accelerator.
(2) The epoxy resin composition for sealing an optical semiconductor according to the aforementioned (1), wherein X is an alkyl group having 1 to 3 carbon atoms substituted by a glycidoxy group or an alkyl group having 1 to 3 carbon atoms substituted by a cycloalkyl group which has an epoxy group and 5 to 8 carbon atoms, R₁ and R₃ are each independently an alkyl group having 1 to 6 carbon atoms, an aryl group or a (meth)acryloyl group.
(3) An optical semiconductor device sealed by a cured product obtained by curing the epoxy resin composition according to the aforementioned (1) or (2).

The cured product of the resin composition for sealing an optical semiconductor of the present invention hardly suffers from degradation by ultraviolet light, and therefore decrease in transparency over time which reduces the brightness of an LED is small. Thus, the resin composition of the present invention is extremely useful as a sealing material for optical semiconductors.

### Best Mode for Carrying Out the Invention

The epoxy resin composition for sealing an optical semiconductor of the present invention contains (A) an epoxy resin obtained by hydrolysis/condensation of an alkoxy-silicon compound(s) represented by the formula (1) by itself or different alkoxy-silicon compounds represented by the formula (1) and the formula (2), respectively:

XSI(R₁)ₙ(OR₂)₃₋ₙ (1)

(wherein X is an organic group having an epoxy group, R₁ is a substituted or unsubstituted alkyl group having 1 to 10 carbon atoms, a substituted or unsubstituted aryl group or a substituted or unsubstituted alkenyl group having 2 to 5 carbon atoms, R₂ is an alkyl group having 1 to 4 carbon atoms, n is an integer of 0 to 2, provided that a plurality of R₁'s exist, the plurality of R₁'s each may be the same or different),

Xₖ(R₃)ₘSi(OR₄)₄₋₍ₖ₊ₘ₎ (2)

(wherein X is an organic group having an epoxy group, R₃ is a substituted or unsubstituted alkyl group having 1 to 10 carbon atoms, a substituted or unsubstituted aryl group or a substituted or unsubstituted unsaturated aliphatic residue, k and m are each independently an integer of 0 to 3 and k+m is 0 to 3, and when a plurality of R₃'s exist, the plurality of R₃'s each may be the same or different, and R₄ is an alkyl group having 1 to 4 carbon atoms), and (B) (i) a cationic polymerization initiator or (ii) a curing agent and a curing accelerator.

The organic group X having an epoxy group in the alkoxy-silicon compounds of the formula (1) and the formula (2) used for producing an epoxy resin (A) employed for the epoxy resin composition for sealing an optical semiconductor of the present invention is not particularly limited as long as the organic group has an epoxy group. Examples thereof include alkyl groups having 1 to 4 carbon atoms substituted by a glycidoxy group such as β-glycidoxyethyl, γ-glycidoxypropyl and γ-glycidoxybutyl; glycidyl groups; and alkyl groups having 1 to 5 carbon atoms substituted by a cycloalkyl group having an oxirane group and 5 to 8 carbon atoms such as β-(3,4-epoxycyclohexyl)ethyl group, γ-(3,4-epoxycyclohexyl)propyl group, β-(3,4-epoxycyclohepthyl)ethyl group, β-(3,4-epoxycyclohexyl)propyl group, β-(3,4-epoxycyclohexyl)butyl group and β-(3,4-epoxycyclohexyl)pentyl group. Of these, alkyl groups having 1 to 3 carbon atoms substituted by a glycidoxy group, alkyl groups having 1 to 3 carbon atoms substituted by a cycloalkyl group having an epoxy group and 5 to 8 carbon atoms, e.g., β-glycidoxyethyl group, γ-glycidoxypropyl group and β-(3,4-epoxycyclohexyl)ethyl group are preferred.

Referring to R₂ in the formula (1) and R₄ in the formula (2), examples of alkyl groups having 1 to 4 carbon atoms include methyl group, ethyl group, n-propyl group, i-propyl group, n-butyl group, i-butyl group and tert-butyl group. These R₂ and R₄ are preferably methyl group or ethyl group from the viewpoint of reaction conditions such as compatibility and reactivity.

R₁ in the formula (1) represents a substituted or unsubstituted alkyl group having 1 to 10 carbon atoms, a substituted or unsubstituted aryl group or a substituted or unsubstituted alkenyl group having 2 to 5 carbon atoms. R₃ in the formula (2) represents a substituted or unsubstituted alkyl group having 1 to 10 carbon atoms, a substituted or unsubstituted aryl group or a substituted or unsubstituted unsaturated aliphatic residue. Specific examples thereof include, as linear or branched substituted or unsubstituted alkyl groups having 1 to 10 carbon atoms, methyl group, ethyl group, n-propyl group, i-propyl group, n-butyl group, t-butyl group, n-pentyl group, i-pentyl group, amyl group, hexyl group, octyl group, 2-ethylhexyl group, nonyl group and decyl group. Examples of substituted or unsubstituted unsaturated aliphatic residues include (meth)acryloyl group. Examples of substituents when such substituent is contained include methyl group, ethyl group, n-propyl group, i-propyl group, n-butyl group, t-butyl group, a halogen atom, vinyl group, allyl group, amino group, nitro group, methoxy group and ethoxy group. Of these, alkyl groups having 1 to 6 carbon atoms, aryl groups and (meth)acryloyl group are preferred.

Preferred specific examples of compounds of the formula (1) include β-glycidoxyethyl trimethoxysilane, β-glycidoxyethyl triethoxysilane, γ-glycidoxypropyl trimethoxysilane, γ-glycidoxypropyl triethoxysilane, γ-glycidoxypropylmethyl dimethoxysilane, γ-glycidoxypropylmethyl diethoxysilane, β-(3,4-epoxycyclohexyl)ethyl trimethoxysilane and β-(3,4-epoxycyclohexyl)ethyl triethoxysilane. These alkoxy-silicon compounds represented by the formula (1) may be used alone or two or more of these may be used.

Preferred specific examples of alkoxy-silicon compounds represented by the formula (2) include β-glycidoxyethylmethyl dimethoxysilane, β-glycidoxyethylmethyl diethoxysilane, γ-glycidoxypropylmethyl dimethoxysilane, γ-glycidoxypropylmethyl diethoxysilane, β-(3,4-epoxycyclohexyl)ethylmethyl dimethoxysilane and β-(3,4-epoxycyclohexyl)ethylmethyl diethoxysilane.

As the alkoxy-silicon compound represented by the formula (2) used in the present invention, compounds having no X may also be used (k=0 in the formula (2)).

Preferred specific examples of such alkoxy-silicon compound having no X include methyltrimethoxysilane, methyltriethoxysilane, hexyltrimethoxysilane, hexyltriethoxysilane, octyltriethoxysilane, decyltrimethoxysilane, dimethyldimethoxysilane, dimethyldiethoxysilane, hexylmethyldimethoxysilane, diphenyldimethoxysilane, diphenyldiethoxysilane, 3-methacryloxypropylmethyldimethoxysilane, 3-methacryloxypropylmethyldiethoxysilane, 3-acryloxypropylmethyldimethoxysilane and 3-acryloxypropylmethyldiethoxysilane.

These alkoxy-silicon compounds represented by the formula (2) may be used alone or two or more of these may be used.

The epoxy resin (A) used for the epoxy resin composition for sealing an optical semiconductor of the present invention can be prepared by hydrolysis/condensation (hereinafter hydrolysis/condensation is simply referred to as condensation) of the alkoxy-silicon compound(s) of the formula (1) by itself, or the alkoxy-silicon compounds represented by the formula (1) and the formula (2).

The proportion for use of the compound represented by the formula (1) and the compound represented by the formula (2) in the condensation reaction may be suitably determined depending on the desired resin properties and curability.

The amount of water to be used in the condensation reaction is usually 0.1 to 1.5 moles, preferably 0.2 to 1.2 moles based on 1 mole of alkoxyl group in the entire reaction system.

The catalyst used in the condensation reaction is not particularly limited as long as it is basic in water, and inorganic bases including alkali metal hydroxides such as sodium hydroxide, potassium hydroxide, lithium hydroxide and cesium hydroxide, and alkali metal carbonates such as sodium carbonate, potassium carbonate, sodium hydrogencarbonate and potassium hydrogencarbonate; organic bases such as ammonia, triethylamine, diethylenetriamine, n-butylamine, dimethylaminoethanol, triethanolamine and tetramethylammonium hydroxide may be used. Of these, from the viewpoint that the catalyst can be easily removed from the product, inorganic bases and ammonia are preferred. The catalyst is added in an amount of usually 0.001 to 7.5% by weight, preferably 0.01 to 5% by weight based on the total weight of the alkoxy-silicon compound in the reaction system.

The condensation reaction may be carried out with or without a solvent. The solvent is not particularly limited as long as it dissolves the alkoxy-silicon compounds of the formula (1) and the formula (2). Examples of such solvent include aprotic polar solvents such as dimethylformamide, dimethylacetamide, tetrahydrofuran, methyl ethyl ketone and methyl isobutyl ketone; and aromatic hydrocarbons such as toluene and xylene. Of these, aprotic polar solvents are preferred. The amount of solvent is not particularly limited as long as it is within the range in which the reaction proceeds smoothly. The solvent is used in an amount of usually about 50 to 900 parts by weight based on 100 parts by weight of the compounds of the formula (1) and the formula (2) in total.

The reaction temperature in the condensation reaction is usually 20 to 160°C, preferably 40 to 140°C depending on the amount of the catalyst. And the reaction time is usually 1 to 12 hours.

Regarding the molecular weight of the epoxy resin (A) used for the epoxy resin composition for sealing an optical semiconductor of the present invention, those having a weight average molecular weight of 400 to 50000 are preferred, and those having a weight average molecular weight of 750 to 30000 are more preferred. When the weight average molecular weight is lower than 400, the heat resistance of the cured product of the composition may be decreased, and when the weight average molecular weight is higher than 50000, the viscosity of the composition is increased, thus causing deterioration in properties.

As for the epoxy resin (A) used for the epoxy resin composition for sealing an optical semiconductor of the present invention, other epoxy resin may be used together within the range that does not affect the properties. When other resin is used together, the epoxy resin A accounts for preferably 20 to 95% by weight, particularly preferably 30 to 95% by weight of the total epoxy resins.

Specific examples of other epoxy resins include polyfunctional epoxy resins which are glycidylated ether products of polyphenol compounds, polyfunctional epoxy resins which are glycidylated ether products of various novolac resins, aromatic ring-hydrogenated products of aromatic epoxy resins, alicyclic epoxy resins, heterocyclic epoxy resins, glycidyl ester epoxy resins, glycidyl amine epoxy resins and epoxy resins obtained by glycidylation of halogenated phenol. Examples of polyfunctional epoxy resins which are glycidylated ether products of polyphenol compounds include those of polyphenol compounds such as bisphenol A, bisphenol F, bisphenol S, 4,4'-biphenol, tetramethyl bisphenol A, dimethyl bisphenol A, tetramethyl bisphenol F, dimethyl bisphenol F, tetramethyl bisphenol S, dimethyl bisphenol S, tetramethyl-4,4-biphenol, dimethyl-4,4'-biphenylphenol, 1-(4-hydroxyphenyl)-2-[4-(1,1-bis-(4-hydroxyphenyl)ethyl)phenyl]propane, 2,2'-methylene-bis(4-methyl-6-tert-butylphenol), 4,4'-butylidene-bis(3-methyl-6-tert-butylphenol), tris-hydroxyphenylmethane, resorcinol, hydroquinone, pyrogallol, phenols having a diisopropylidene skeleton, phenols having a fluorene skeleton such as 1,1-di-4-hydroxyphenylfluorene and phenolated polybutadiene. Specific examples of polyfunctional epoxy resins which are glycidylated ether products of various novolac resins include glycidylated ether products of novolac resins prepared from various phenols as starting materials, such as phenol, cresol, ethyl phenol, butyl phenol, octyl phenol, bisphenol A, bisphenol F, bisphenol S and naphthol, phenol novolac resins containing a xylylene skeleton, phenol novolac resins containing a dicyclopentadiene skeleton, phenol novolac resins containing a biphenyl skeleton and phenol novolac resins containing a fluorene skeleton. Examples of aromatic ring-hydrogenated products of aromatic epoxy resins include those of glycidylated ether products of phenol compounds such as bisphenol A, bisphenol F, bisphenol S and 4,4'-biphenol, and those of glycidylated ether products of novolac resins prepared from various phenols as starting materials, such as phenol, cresol, ethyl phenol, butyl phenol, octyl phenol, bisphenol A, bisphenol F, bisphenol S and naphthol. Examples of alicyclic epoxy resins include alicyclic epoxy resins having an aliphatic skeleton, e.g., cyclohexane or the like, such as 3,4-epoxycyclohexylmethyl-3',4'-cyclohexyl carboxylate. Examples of aliphatic epoxy resins include glycidyl ethers of polyhydric alcohols such as 1,4-butanediol, 1,6-hexanediol, polyethylene glycol, polypropylene glycol, pentaerythritol and xylylene glycol derivatives. Examples of heterocyclic epoxy resins include heterocyclic epoxy resins having a heterocycle such as isocyanuric ring or hydantoin ring. Examples of glycidyl ester epoxy resins include epoxy resins composed of carboxylic acid, such as hexahydrophthalic acid glycidyl ester and tetrahydrophthalic acid glycidyl ester. Examples of glycidyl amine epoxy resins include those obtained by glycidylation of amines such as aniline, toluidine, p-phenylenediamine, m-phenylenediamine, diaminodiphenylmethane derivatives and diaminomethylbenzene derivatives. Examples of epoxy resins obtained by glycidylation of halogenated phenol include brominated bisphenol A, brominated bisphenol F, brominated bisphenol S, brominated phenol novolac, brominated cresol novolac, chlorinated bisphenol S and chlorinated bisphenol A.

These epoxy resins may be used without any particular limitation, but from the viewpoint of transparency, those causing little coloring are preferred. Usually used are polyfunctional epoxy resins which are glycidylated ether products of phenols such as bisphenol A, bisphenol F, bisphenol S, 4,4'-biphenol, tetramethyl-4,4'-biphenol, 1-(4-hydroxyphenyl)-2-[4-(1,1-bis-(4-hydroxyphenyl)ethyl)phenyl]propane, tris-hydroxyphenylmethane, resorcinol, 2,6-di-tert-butylhydroquinone, phenols having a diisopropylidene skeleton and phenols having a fluorene skeleton such as 1,1-di-4-hydroxyphenylfluorene; glycidylated ether products of various novolac resins such as novolac resins prepared from various phenols as starting materials, such as phenol, cresol, bisphenol A, bisphenol S and naphthol, phenol novolac resins containing a dicyclopentadiene skeleton, phenol novolac resins containing a biphenyl skeleton and phenol novolac resins containing a fluorene skeleton; aromatic ring-hydrogenated products of various glycidylated ether products such as glycidylated ether products of phenol compounds such as bisphenol A, bisphenol F, bisphenol S and 4,4'-biphenol and glycidylated ether products of novolac resins prepared from various phenols as starting materials, such as phenol, cresol, ethyl phenol, butyl phenol, octyl phenol, bisphenol A, bisphenol F, bisphenol S and naphthol; alicyclic epoxy resins having a cyclohexane skeleton such as 3,4-epoxycyclohexylmethyl-3',4'-cyclohexyl carboxylate; glycidyl ethers of 1,6-hexanediol, polyethylene glycol or polypropylene glycol; triglycidyl isocyanurate; and hexahydrophthalic acid glycidyl ester. Further, one or a mixture of two or more of these epoxy resins may be used in order to provide heat resistance, etc., where necessary.

As the component (B), (i) a cationic polymerization initiator or (ii) a curing agent and a curing accelerator are incorporated into the epoxy resin composition for an optical semiconductor of the present invention. When the cationic polymerization initiator (i) is added to the composition as the component (B), the epoxy resin composition is cured by cationic polymerization of the epoxy resin which is the component (A). On the other hand, when the curing agent and the curing accelerator (ii) are added to the composition as the component (B), the epoxy resin composition is cured by a reaction between an epoxy group and an alkoxyl group (and another group in some cases) that the epoxy resin of the component (A) has with various reactive groups that the curing agent and the curing accelerator have.

As the cationic polymerization initiator used as the component (B) of the epoxy resin composition for an optical semiconductor of the present invention, those may be used without any particular limitation which can produce Bronsted acid or Lewis acid to start bonding of epoxy groups by irradiation of active energy rays such as visible rays, ultraviolet rays, X-rays and electron beam, or by heating. Examples of cationic photopolymerization initiators include diazonium salts, sulfonium salts and iodonium salts. Examples of cationic thermopolymerization initiators include onium salts such as sulfonium salts, ammonium salts and phosphonium salts, and silanol-aluminum complexes.

Specific examples of such cationic photopolymerization initiators include benzenediazonium hexafluoroantimonate, benzenediazonium hexafluorophosphate, benzenediazonium hexafluoroborate, triphenylsulfonium hexafluoroantimonate, triphenylsulfonium hexafluorophosphate, triphenylsulfonium hexafluoroborate, 4,4'-bis[bis(2-hydroxyethoxyphenyl)sulfonio]phenylsulfide bishexafluorophosphate, diphenyliodonium hexafluoroantimonate, diphenyliodonium hexafluorophosphate and diphenyl-4-thiophenoxyphenylsulfonium hexafluorophosphate.

These cationic photopolymerization initiators are available as commercial products. Examples thereof include KAYARAD PCI-220 and KAYARAD PCI-620 (both available from NIPPON KAYAKU CO., LTD.), UVI-6990 (available from Union Carbide Corporation), ADEKA OPTOMER SP-150 and ADEKA OPTOMER SP-170 (both available from ASAHI DENKA Co., Ltd.), CIT-1370, CIT-1682, CIP-1866S, CIP-2048S, CIP-2064S (all available from NIPPON SODA CO., LTD.), DPI-101, DPI-102, DPI-103, DPI-105, MPI-103, MPI-105, I-101, BBI-102, BBI-103, BBI-105, TPS-101, TPS-102, TPS-103, TPS-105, MDS-103, MDS-105, DTS-102, DTS-103 (all available from Midori Kagaku Co., Ltd.).

These cationic photopolymerization initiators may be used alone or in a mixture of two ore more. When the cationic photopolymerization initiator is used as the component (B) of the epoxy resin composition of the present invention, the content thereof is preferably 0.5 to 20% by weight, particularly preferably 0.7 to 15% by weight based on the solid components of the composition.

Specific examples of cationic thermopolymerization initiators include aryl sulfonium complex salts described in U.S. Patent No. 4,231,951; aromatic iodonium complex salts and aromatic sulfonium complex salts described in U.S. Patent No. 4,256,828; bis[4-(diphenylsulfonio)phenyl]sulfide-bis-hexafluoro metal salts (e.g., phosphate, arsenate and antimonate) described in Journal of Polymer Science, Polymer Chemistry, W.R. Watt et al., Vol. 22, p.1789 (1984); metal fluoroborate complex salts and boron trifluoride complex compounds described in U.S. Patent No. 3,379,653; bis(perfluoroalkylsulfonyl)methane metal salts described in U.S. Patent No. 3,586,616; aryldiazonium compounds described in U.S. Patent No. 3,708,296; aromatic onium salts of Group VIa elements described in U.S. Patent No. 4,058,400; aromatic onium salts of Group Va elements described in U.S. Patent No. 4,069,055; dicarbonyl chelates of Group IIIa to Va elements described in U.S. Patent No. 4,068,091; thiopyrylium salts described in U.S. Patent No. 4,139,655; and Group VIb elements in the form of a MF6-anion (where M is selected from phosphorus, antimony and arsenic) described in U.S. Patent No. 4,161,478.

These cationic thermopolymerization initiators are available as commercial products. Examples thereof include CI-2855, CI-2624 (both available from NIPPON SODA CO., LTD.), CAT EX-1 (DAICEL CHEMICAL INDUSTRIES LTD.), ADEKA OPTOMER CP-66, ADEKA OPTOMER CP-67 (both available from ASAHI DENKA Co., Ltd.), San-Aid SI-60L, San-Aid SI-80L, San-Aid SI-1000L (all available from SANSHIN CHEMICAL INDUSTRY CO., LTD.), and NB-101, NB-201 (available from Midori Kagaku Co., Ltd.).

These cationic thermopolymerization initiators may be used alone or in a mixture of two or more kinds. When the cationic thermopolymerization initiator is used as the component (B) of the epoxy resin composition of the present invention, the content thereof is preferably 0.01 to 20% by weight, particularly preferably 0.5 to 15% by weight based on the solid components of the composition.

As for the curing agent used together with a curing accelerator as the component (B) of the epoxy resin composition for sealing an optical semiconductor of the present invention, amine compounds, acid anhydride compounds, amide compounds and phenol compounds which are generally used as a curing agent of an epoxy resin may be used without any particular limitation. Specific examples thereof include diaminodiphenylmethane, diethylenetriamine, triethylenetetramine, diaminodiphenylsulfone, isophoronediamine, dicyandiamide, tetraethylenepentamine, dimethylbenzylamine, ketimine compounds, polyamide resins synthesized from a dimer of linolenic acid and ethylenediamine, phthalic anhydride, trimellitic anhydride, pyromellitic anhydride, maleic anhydride, tetrahydrophthalic anhydride, methyltetrahydrophthalic anhydride, methylnadic anhydride, hexahydrophthalic anhydride, methylhexahydrophthalic anhydride, bisphenols, condensation polymers of phenol (phenol, alkyl substituted phenol, naphthol, alkyl substituted naphthol, dihydroxybenzene, dihydroxynaphthalene) and various aldehydes, polymers of phenol and various diene compounds, condensation polymers of phenol and aromatic dimethylol, condensation products of bismethoxymethylbiphenyl and naphthol or phenol, biphenols and modified types thereof, imidazoles, boron trifluoride-amine complexes and guanidine derivatives.

When the curing agent and the curing accelerator are used as the component (B) of the epoxy resin composition of the present invention, the amount to be used of the curing agent is preferably 0.2 to 1.5 equivalents, particularly preferably 0.3 to 1.2 equivalents based on 1 equivalent of epoxy group in the composition. When a tertiary amine such as benzyldimethylamine is used as the curing agent, the amount to be used of the curing agent is preferably 0.3 to 20% by weight, particularly preferably 0.5 to 10% by weight based on the epoxy group-containing compound in the composition.

Examples of curing accelerators used together with the curing agent as the component (B) of the epoxy resin composition for sealing an optical semiconductor of the present invention include imidazoles such as 2-methylimidazole, 2-phenylimidazole, 2-undecylimidazole, 2-heptadecylimidazole, 2-phenyl-4-methylimidazole, 1-benzyl-2-phenylimidazole, 1-benzyl-2-methylimidazole, 1-cyanoethyl-2-methylimidazole, 1-cyanoethyl-2-phenylimidazole, 1-cyanoethyl-2-undecylimidazole, 2,4-diamino-6(2'-methylimidazole(1'))ethyl-s-triazine, 2,4-diamino-6(2'-undecylimidazole(1'))ethyl-s-triazine, 2,4-diamino-6(2'-ethyl,4-methylimidazole(1'))ethyl-s-triazine, a 2,4-diamino-6(2'-methylimidazole(1'))ethyls-triazine isocyanuric acid adduct, a 2:3 adduct of 2-methylimidazole and isocyanuric acid, a 2-phenylimidazole isocyanuric acid adduct, 2-phenyl-3,5-dihydroxymethylimidazole, 2-phenyl-4-hydroxymethyl-5-methylimidazole and 1-cyanoethyl-2-phenyl-3,5-dicyanoethoxymethylimidazole; salts formed from such imidazoles and polyvalent carboxylic acids such as phthalic acid, isophthalic acid, terephthalic acid, trimellitic acid, pyromellitic acid, naphthalene dicarboxylic acid, maleic acid and oxalic acid; amides such as dicyandiamide; diaza compounds such as 1,8-diaza-bicyclo(5.4.0)undecene-7; salts formed from such diaza compounds and tetraphenylborate or phenol novolac, salts formed from those and the aforementioned polyvalent carboxylic acid or salts formed from those and phosphinic acid; ammonium salts such as tetrabutylammonium bromide, cetyltrimethylammonium bromide and trioctylmethylammonium bromide; phosphines and phosphonium compounds such as triphenylphosphine, tri(tolyl)phosphine, tetraphenylphosphonium bromide and tetraphenylphosphonium tetraphenylborate; phenols such as 2,4,6-tris(aminomethyl)phenol; amine adducts; and microcapsule curing accelerators formed by microcapsulation of these curing agents. Which of the curing accelerators is to be used is accordingly determined depending on the properties required for the obtained transparent resin composition, e.g., the transparency, curing speed and working conditions. When the curing agent and the curing accelerator are used as the component (B) of the epoxy resin composition of the present invention, the amount to be used of the curing accelerator is generally in the range of preferably 0.01 to 15 parts by weight based on 100 parts by weight of the epoxy resin.

An inorganic filler, a colorant, a coupling agent, a leveling agent or a lubricant may be added to the epoxy resin composition of the present invention depending on the intended purposes within the range that the transparency is not lost.

Examples of inorganic fillers include, but not limited to, crystalline or amorphous silica, talc, silicon nitride, boron nitride, alumina and mixed melt silica-titania.

Examples of colorants include, but not limited to, various organic pigments of phthalocyanine, azo, disazo, quinacridone, anthraquinone, flavanthrone, perinone, perylene, dioxazine, condensed azo and azomethine; and inorganic pigments such as titanium oxide, lead sulfate, chrome yellow, zinc yellow, chrome vermilion, iron oxide red, cobalt violet, iron blue, ultramarine, carbon black, chrome green, chromium oxide and cobalt green.

Examples of leveling agents include oligomers having a number average molecular weight of 4000 to 12000 composed of an acrylate such as ethyl acrylate, butyl acrylate or 2-ethylhexyl acrylate, epoxidized soya fatty acid, epoxidized abietyl alcohol, hydrogenated castor oil and titanium coupling agents.

Examples of lubricants include hydrocarbon lubricants such as paraffin wax, microcrystalline wax and polyethylene wax; higher fatty acid lubricants such as lauric acid, myristic acid, palmitic acid, stearic acid, arachidic acid and behenic acid; higher fatty acid amide lubricants such as stearylamide, palmitylamide, oleylamide, methylenebisstearoamide and ethylenebisstearoamide; higher fatty acid ester lubricants such as hydrogenated castor oil, butyl stearate, ethylene glycol monostearate and pentaerythritol (mono-, di-, tri- or tetra)stearate; alcohol lubricants such as cetyl alcohol, stearyl alcohol, polyethylene glycol and polyglycerol; metal soaps which are metal salts formed from lauric acid, myristic acid, palmitic acid, stearic acid, arachidic acid, behenic acid, ricinoleic acid or naphthenic acid with magnesium, calcium, cadmium, barium, zinc or lead; and natural waxes such as carnauba wax, candelilla wax, beeswax and montan wax.

Examples of coupling agents include silane coupling agents such as 3-glycidoxypropyl trimethoxysilane, 3-glycidoxypropyl methyldimethoxysilane, 3-glycidoxypropyl methyldimethoxysilane, 2-(3,4-epoxycyclohexyl)ethyl trimethoxysilane, N-(2-aminoethyl)3-aminopropyl methyldimethoxysilane, N-(2-aminoethyl)3-aminopropyl methyltrimethoxysilane, 3-aminopropyl triethoxysilane, 3-mercaptopropyl trimethoxysilane, vinyltrimethoxysilane, N-(2-(vinylbenzylamino)ethyl)3-aminopropyltrimethoxysilane hydrochloride, 3-methacryloxypropyl trimethoxysilane, 3-chloropropyl methyldimethoxysilane and 3-chloropropyl trimethoxysilane; titanium coupling agents such as isopropyl(N-ethylaminoethylamino) titanate, isopropyl triisostearoyl titanate, titanium di(dioctyl pyrophosphate) oxyacetate, tetraisopropyl di(dioctylphosphite)titanate and neoalkoxy tri(p-N-(β-aminoethyl)aminophenyl)titanate; and zirconium or aluminum coupling agents such as Zr-acetylacetonato, Zr-methacrylate, Zr-propionate, neoalkoxy zirconate, neoalkoxy trisneodecanoyl zirconate, neoalkoxy tris(dodecanoyl)benzenesulfonyl zirconate, neoalkoxy tris(ethylenediamino)ethyl zirconate, neoalkoxy tris(m-aminophenyl)zirconate, ammonium zirconium carbonate, Al-acetylacetonate, Al-methacrylate and Al-propionate.

The epoxy resin composition for sealing an optical semiconductor of the present invention can be obtained by mixing components, i.e., an epoxy resin which is the component (A) and (i) a cationic polymerization initiator or (ii) a curing agent and a curing accelerator which are the component (B), and if necessary, an inorganic filler, a coupling agent, a colorant or a leveling agent, using a mixer such as a Henschel mixer or a Nauta mixer when the components are solid, then by kneading using a kneader, extruder and a heating roll at 80 to 120°C, cooling and then pulverizing into powder. On the other hand, when the components are liquid, the epoxy resin composition of the present invention is prepared by uniformly dispersing the components using a planetary mixer or the like.

To obtain the optical semiconductor of the present invention by sealing an optical semiconductor such as an LD, a photosensor or a transceiver using the epoxy resin composition of the present invention prepared as above, molding may be performed by a conventional molding technique such as transfer molding, compression molding, injection molding or printing.

### (Examples)

The present invention will now be described in detail by means of Examples, but the present invention is not limited to these Examples. In the Examples, "part(s)" represent "part by weight" unless otherwise specified. The values of physical properties in the Examples were measured by the following methods.
(1) Weight average molecular weight: measured by gel permeation chromatography (GPC).
(2) Epoxy equivalent: measured by the method described in JIS K-7236.

### [Synthesis Example 1]

A reactor was charged with 94.4 parts of γ-glycidoxypropyl trimethoxysilane and 94.4 parts of methyl isobutyl ketone, and heated to 80°C. After heating, 10.8 parts of a 0.1% by weight aqueous potassium hydroxide solution was continuously added thereto dropwise over 30 minutes. After completion of the dropwise addition, the mixture was allowed to react under reflux at 80°C for 5 hours. After completion of the reaction, water washing was repeated until the wash water was neutral. The solvent was then removed under reduced pressure to give 66 parts of an epoxy resin (A-1). The obtained epoxy resin had an epoxy equivalent of 171 g/eq and a weight average molecular weight of 2200.

### [Synthesis Example 2]

A reactor was charged with 100 parts of β-(3,4-epoxycyclohexyl)ethyl trimethoxysilane and 100 parts of methyl isobutyl ketone, and heated to 80°C. After heating, 11 parts of a 0.1% by weight aqueous potassium hydroxide solution was continuously added thereto dropwise over 30 minutes. After completion of the dropwise addition, the mixture was allowed to react under reflux at 80°C for 5 hours. After completion of the reaction, water washing was repeated until the wash water was neutral. The solvent was then removed under reduced pressure to give 69 parts of an epoxy resin (A-2). The obtained compound had an epoxy equivalent of 184 g/eq and a weight average molecular weight of 2500.

### [Synthesis Example 3]

A reactor was charged with 89 parts of γ-glycidoxypropyl trimethoxysilane, 26 parts of hexyltrimethoxysilane and 115 parts of methyl isobutyl ketone, and heated to 80°C. After heating, 13.5 parts of a 0.1% by weight aqueous potassium hydroxide solution was continuously added thereto dropwise over 30 minutes. After completion of the dropwise addition, the mixture was allowed to react under reflux at 80°C for 5 hours. After completion of the reaction, water washing was repeated until the wash water was neutral. The solvent was then removed under reduced pressure to give 80 parts of an epoxy compound (A-3). The obtained compound had an epoxy equivalent of 216 g/eq and a weight average molecular weight of 3200.

### [Synthesis Example 4]

A reactor was charged with 47.3 parts of γ-glycidoxypropyl trimethoxysilane, 24 parts of dimethyldimethoxysilane and 285.2 parts of methyl isobutyl ketone, and heated to 80°C. After heating, 10.8 parts of a 0.1% by weight aqueous potassium hydroxide solution was continuously added thereto dropwise over 30 minutes. After completion of the dropwise addition, the mixture was allowed to react under reflux at 80°C for 5 hours. After completion of the reaction, water washing was repeated until the wash water was neutral. The solvent was then removed under reduced pressure to give 46 parts of an epoxy resin (A-4). The obtained compound had an epoxy equivalent of 240 g/eq, a weight average molecular weight of 1400 and a viscosity of 370 mPa·s.

### [Examples 1 to 8]

The above-described epoxy resins and the raw materials described below are mixed at weight ratios shown in the "composition of components" in Table 1 to prepare epoxy resin compositions of the present invention.
(B-1) Cationic photopolymerization initiator:
   triphenylsulfonium hexafluoroantimonate ("ADEKA OPTOMER SP-170" available from ASAHI DENKA Co., Ltd.)
(B-2) Cationic thermopolymerization initiator: organic sulfonium hexafluorophosphate ("CI-2855" available from NIPPON SODA CO., LTD.)
(B-3) Curing agent: 4-methylhexahydrophthalic anhydride ("MH-700G" available from New Japan Chemical Co., Ltd.)
(B-4) Curing accelerator: quaternary phosphonium bromide ("U-CAT 5003" available from SAN-APRO Limited.)

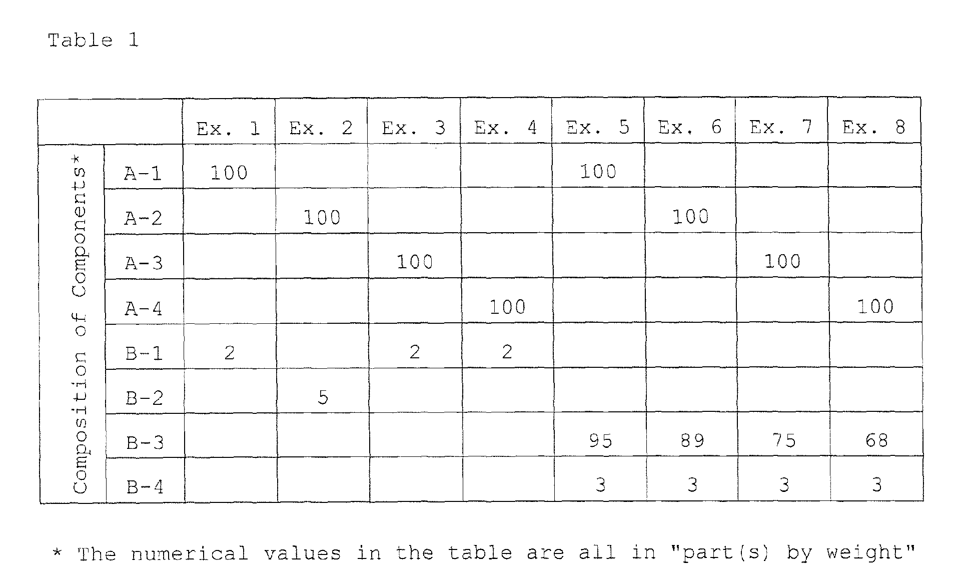

The epoxy resin compositions obtained in Examples 1 to 4 and 5 to 8 were subjected to a test of transmittance described below, and the results are shown in Table 2 (Examples 1 to 4) and Table 3 (Examples 5 to 8).

### (Test of transmittance)

The epoxy resin compositions obtained in Examples 1, 3 and 4 were poured into a mold and cured by irradiating with ultraviolet light of 520 m/Jcm² using a high-pressure mercury lamp (120 w/cm²) at a distance of 3.5 cm to give test pieces of 20 mm × 15 mm, 1 mm in thickness. The epoxy resin composition obtained in Example 2 was formed into a test piece of 20 mm × 15 mm, 1 mm in thickness by casting under a curing condition of 150°C × 3 hours. On the other hand, the epoxy resin compositions obtained in Examples 5 to 8 were formed into test pieces of 20 mm × 15 mm, 1 mm in thickness by casting under a curing condition of 120°C × 2 hours.

Using these test pieces, the transmittance was measured before and after the ultraviolet irradiation (measured wavelength: 400 nm) by a spectrophotometer. The conditions of the ultraviolet irradiation are as follows:
Ultraviolet irradiation equipment: EYE SUPER UV TESTER SUV-W11
Temperature: 60°C
Irradiation energy: 65 mW/cm²
Irradiation time: =7 hours

**Table 2**

| | Transmittance (%) before ultraviolet irradiation | Transmittance (%) after ultraviolet irradiation (for 7 hours) |
|---|---|---|
| Ex. 1 | 93 | 90 |
| Ex. 2 | 95 | 92 |
| Ex. 3 | 95 | 93 |
| Ex. 4 | 96 | 93 |

**Table 3**

| | Transmittance (%) before ultraviolet irradiation | Transmittance (%) after ultraviolet irradiation (for 7 hours) |
|---|---|---|
| Ex. 5 | 91 | 88 |
| Ex. 6 | 92 | 88 |
| Ex. 7 | 92 | 89 |
| Ex. 8 | 91 | 89 |

The results of Tables 2 and 3 revealed that the epoxy resin composition of the present invention could provide a cured product with little degradation by ultraviolet light and excellent in transparency.

### Industrial Applicability

The resin composition of the present invention is very useful for industrial applications as a sealing material for optical semiconductor elements such as LEDs, CCDs and photocouplers, and particularly ultraviolet LEDs.

## Claims

1. An epoxy resin composition for sealing an optical semiconductor, comprising
(A) an epoxy resin obtained by hydrolysis/condensation of an alkoxy-silicon compound(s) represented by the formula (1) by itself or different alkoxy-silicon compounds represented by the formula (1) and the formula (2), respectively:
XSi(R₁)ₙ(OR₂)₃₋ₙ (1)
(wherein X is an organic group having an epoxy group, R₁ is a substituted or unsubstituted alkyl group having 1 to 10 carbon atoms, a substituted or unsubstituted aryl group, or a substituted or unsubstituted alkenyl group having 2 to 5 carbon atoms, R₂ is an alkyl group having 1 to 4 carbon atoms, n is an integer of 0 to 2, provided that a plurality of R₁'s exist, the plurality of R₁'s may be the same or different); and
Xₖ(R₃)ₘSi(OR₄)₄₋₍ₖ₊ₘ₎ (2)
(wherein X is an organic group having an epoxy group, R₃ is a substituted or unsubstituted alkyl group having 1 to 10 carbon atoms, a substituted or unsubstituted aryl group, or a substituted or unsubstituted unsaturated aliphatic residue, k and m are each independently an integer of 0 to 3 and k+m is 0 to 3, provided that a plurality of R₃'s exist, the plurality of R₃'s may be the same or different, and R₄ is an alkyl group having 1 to 4 carbon atoms); and
(B) (i) a cationic polymerization initiator or (ii) a curing agent and a curing accelerator.

2. The epoxy resin composition for sealing an optical semiconductor according to claim 1, wherein X is an alkyl group having 1 to 3 carbon atoms substituted by a glycidoxy group, or an alkyl group, having 1 to 3 carbon atoms substituted by a cycloalkyl group which has an epoxy group and 5 to 8 carbon atoms, and R₁ and R₃ are each independently an alkyl group having 1 to 6 carbon atoms, an aryl group or a (meth)acryloyl group.

3. An optical semiconductor device sealed by a cured product obtained by curing the epoxy resin composition according to claim 1 or 2.
